# DEMANDE DE BREVET EUROPEEN

(11) **EP 4 783 759 A1**
(43) Date de publication de la demande: **29.07.2026**
(21) Numéro de dépôt: 26151645.4
(22) Date de dépôt: 13.01.2026
(51) Int. Cl.: H05K 7/14, H05K 7/20, B65D 88/74, G06F 1/20

(54) **ENSEMBLE CONTENEUR COMPORTANT UN CONTENEUR ET UN SYSTÈME DE GESTION DE LA TEMPÉRATURE À L'INTÉRIEUR DU CONTENEUR**

(30) Priorité: 14.01.2025 FR 2500372
(71) Demandeur: Cordon Electronics, 22100 Taden (FR)
(72) Inventeur: BEIGE, Thierry, 22100 Taden (FR); KRAUS, Denis, 22100 Taden (FR)
(74) Mandataire: Cabinet Le Guen Maillet

(57) **Abrégé**

L'invention concerne un ensemble conteneur (100) comportant un conteneur (102), deux rangées (104a-b) de racks (106) divisant le conteneur (102) en un couloir froid (152a) et deux couloirs chauds (152b), un faux plafond (108) pour délimiter un volume de circulation (160), où le faux plafond (108) est traversé par une fenêtre d'introduction (108a) débouchant dans le couloir froid (152a) et deux fenêtres de rejet (108b-c) débouchant dans chaque couloir chaud (152b-c), un condenseur (160), pour chaque fenêtre de rejet (108b-c), un évaporateur (162) arrangé entre ladite fenêtre de rejet (108b-c) et la fenêtre d'introduction (108a), où chaque évaporateur (162) comporte un ventilateur (162a) générant un flux d'air de ladite fenêtre de rejet (108b-c) vers la fenêtre d'introduction (108a), et un circuit frigorifique (164) de fluide caloporteur circulant entre chaque évaporateur (162) et ledit au moins un condenseur (160).

## Description

### DOMAINE TECHNIQUE

La présente invention se rapporte au domaine des conteneurs et plus particulièrement des conteneurs qui sont équipés de systèmes informatiques, de systèmes de télécommunications, ou autres. C'est-à-dire des conteneurs contenant des appareils qui, en fonctionnant, réchauffent le volume intérieur du conteneur qui doit donc être refroidi. L'invention concerne en particulier un ensemble conteneur comportant un conteneur et un système de gestion de la température qui assure la régulation de la température du volume intérieur du conteneur.

### ÉTAT DE LA TECHNIQUE ANTÉRIEURE

Un ensemble conteneur de l'état de la technique comporte classiquement un conteneur dans lequel des racks de rangement sur lesquels sont installés des appareils électroniques et un système de climatisation qui régule la température à l'intérieur du conteneur.

Bien qu'un tel ensemble conteneur donne satisfaction, il est souhaitable de trouver un arrangement qui assure une meilleure régulation.

### EXPOSÉ DE L'INVENTION

Un objet de la présente invention est de proposer un ensemble conteneur comportant un conteneur et un système particulier de gestion de la température.

À cet effet, est proposé un ensemble conteneur comportant :
- un conteneur comportant un plancher, un plafond, une paroi frontale, une paroi dorsale, une première paroi latérale et une deuxième paroi latérale,
- une première rangée de racks et une deuxième rangée de racks, où chaque rangée s'étend entre la paroi frontale et la paroi dorsale de manière à diviser un volume intérieur du conteneur en un couloir froid entre les deux rangées, un premier couloir chaud entre la première paroi latérale et la première rangée et un deuxième couloir chaud entre la deuxième paroi latérale et la deuxième rangée,
- un faux plafond s'étendant entre les racks et le plafond, de manière à délimiter entre le plafond et le faux plafond, un volume de circulation, où le faux plafond est traversé par une fenêtre d'introduction débouchant entre le volume de circulation et le couloir froid, une première fenêtre de rejet débouchant entre le volume de circulation et le premier couloir chaud et une deuxième fenêtre de rejet débouchant entre le volume de circulation et le deuxième couloir chaud,
- au moins un condenseur arrangé dans le conteneur,
- pour chaque fenêtre de rejet, au moins un évaporateur arrangé dans le volume de circulation entre ladite fenêtre de rejet et la fenêtre d'introduction, où chaque évaporateur comporte un ventilateur arrangé pour générer un flux d'air de ladite fenêtre de rejet vers la fenêtre d'introduction, et
- un circuit frigorifique arrangé pour assurer la circulation d'un fluide caloporteur entre chaque évaporateur et ledit au moins un condenseur.

Avantageusement, les évaporateurs délimitent ensemble un sous-volume du volume de circulation autour de la fenêtre d'introduction, où le sous-volume est étanche par rapport au reste du volume de circulation.

Avantageusement, le conteneur comporte une paroi de séparation entre la deuxième rangée et la deuxième paroi latérale délimitant un volume technique entre la paroi de séparation et la deuxième paroi latérale et ledit au moins un condenseur est disposé dans ledit volume technique.

Avantageusement, l'ensemble conteneur comporte un générateur électrique embarqué dans ledit volume technique.

Avantageusement, la deuxième paroi présente une porte extérieure assurant l'accès audit volume technique.

Avantageusement, pour chaque couloir chaud, la paroi frontale et/ou la première paroi latérale délimitant ledit couloir chaud présente une porte extérieure assurant l'accès audit couloir chaud. Avantageusement, l'une des rangées présente une porte intérieure assurant l'accès audit couloir froid depuis le couloir chaud associé à ladite rangée.

### BRÈVE DESCRIPTION DES DESSINS

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
[Fig. 1] représente une vue de dessus sans toit et sans faux plafond d'un ensemble conteneur selon l'invention,
[Fig. 2] est une vue en perspective sans une des parois latérales de l'ensemble conteneur selon l'invention, et
[Fig. 3] est une vue de côté de l'ensemble conteneur selon l'invention.

### EXPOSÉ DÉTAILLÉ DE MODES DE RÉALISATION

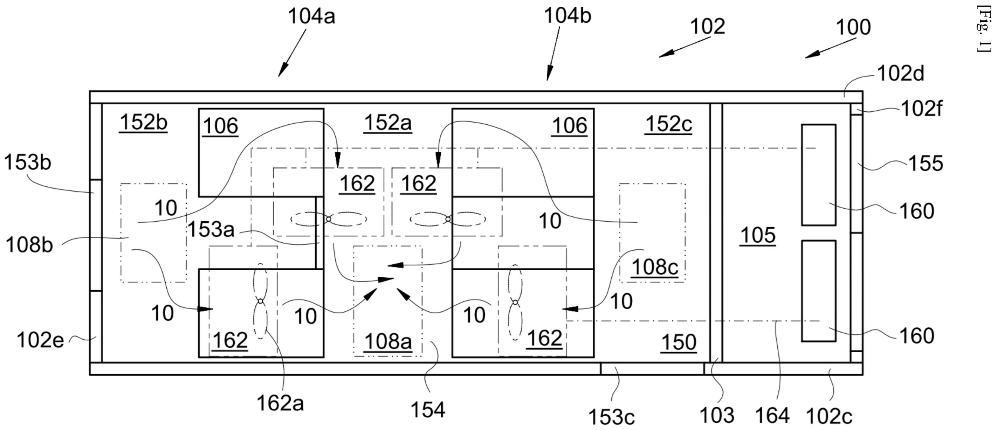

Les Figs. 1 à 3 montrent un ensemble conteneur 100 qui comporte un conteneur 102 qui présente lui-même de manière classique un plancher 102a, un plafond 102b, une paroi frontale 102c, une paroi dorsale 102d, une première paroi latérale 102e et une deuxième paroi latérale 102f. Les parois 102a-f délimitent un volume intérieur 150.

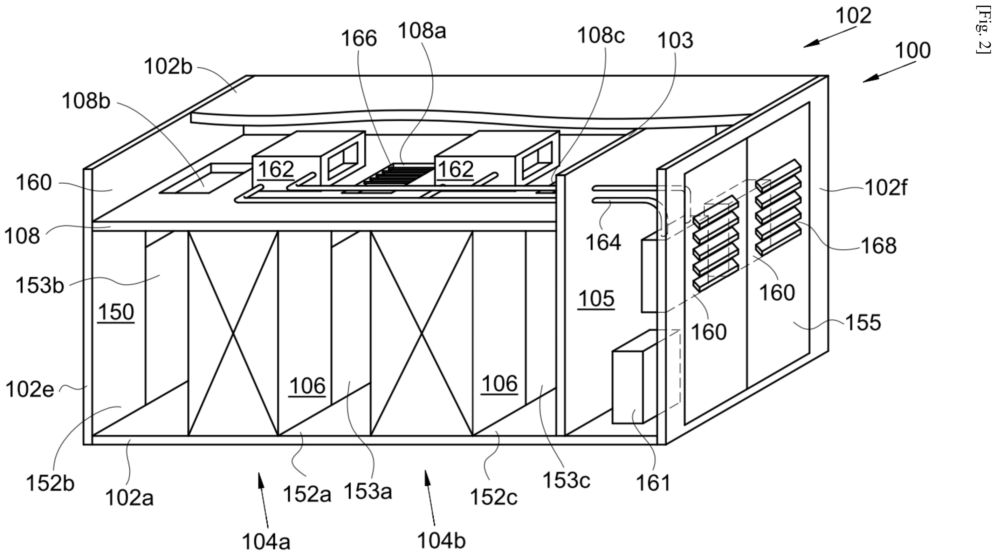

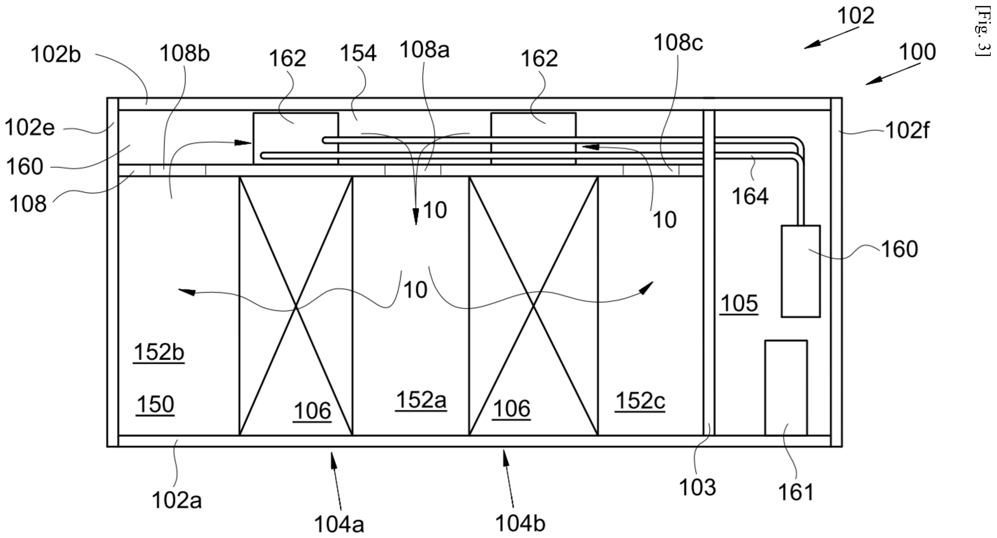

La Fig. 1 montre l'ensemble conteneur 100 sans le plafond 102b, la Fig. 2 et la Fig. 3 montrent l'ensemble conteneur 100 sans la paroi frontale 102c.

Le conteneur est préférentiellement réalisé en métal. Pour faciliter le transport du conteneur 102, ce dernier peut comporter des coins d'accrochage au niveau des coins du plafond 102b pour y fixer les crochets d'une grue, et/ou des passages pour des fourches d'un chariot élévateur sous le plancher 102a.

Le conteneur est de forme parallélépipédique à base rectangulaire où les parois frontale 102c et dorsale 102d constituent les parois de grandes dimensions et les parois latérales 102e-f constituent les parois de petites dimensions. Les parois frontale 102c et dorsale 102d sont parallèles entre elles et les parois latérales 102e-f sont parallèles entre elles.

L'ensemble conteneur 100 comporte également une première rangée 104a de racks 106 et une deuxième rangée 104b de racks 106. Les racks 106 sont destinés à recevoir des modules électriques du type télécommunication, informatique ou autres. Chaque module électrique est alimenté en électricité et du fait de son fonctionnement, il génère de la chaleur qui réchauffe le volume intérieur 150 du conteneur 102.

Les rangées 104a-b s'étendent parallèlement l'une par rapport à l'autre et chaque rangée 104a-b s'étend entre la paroi frontale 102c et la paroi dorsale 102d. La première rangée 104a est disposée la plus près de la première paroi latérale 102e et la deuxième rangée 104b est disposée la plus près de la deuxième paroi latérale 102f. Les rangées 104a-b divisent le volume intérieur 150 du conteneur 102 en un couloir froid 152a, un premier couloir chaud 152b et un deuxième couloir chaud 152c. Le couloir froid 152a est entre les deux rangées 104a-b, le premier couloir chaud 152b est entre la première paroi latérale 102e et la première rangée 104a et le deuxième couloir chaud 152c est entre la deuxième paroi latérale 102f et la deuxième rangée 104b.

Un tel arrangement des rangées 104a-b permet une séparation entre un couloir froid 152a et deux couloirs chauds 152b-c distincts ce qui facilite la gestion de la température comme cela est explicité ci-dessous.

L'ensemble conteneur 100 comporte également un faux plafond 108 qui s'étend au-dessus des racks 106 entre ces derniers et le plafond 102b. Dans le mode de réalisation de l'invention représenté sur les Figs., le faux plafond 108 ne s'étend pas jusqu'à la deuxième paroi latérale 102f du fait de la présence d'une paroi de séparation 103 dont la fonction est décrite ci-dessous, mais dans un autre mode de réalisation non représenté, le faux plafond 108 peut s'étendre jusqu'à la deuxième paroi latérale 102f et s'étendre par exemple au-dessus de la paroi de séparation 103.

Un volume de circulation 160 est ainsi délimité entre le plafond 102b et le faux plafond 108. Le faux plafond 108 est traversé par une fenêtre d'introduction 108a qui débouche entre le volume de circulation 160 et le couloir froid 152a, une première fenêtre de rejet 108b qui débouche entre le volume de circulation 160 et le premier couloir chaud 152b et une deuxième fenêtre de rejet 108c qui débouche entre le volume de circulation 160 et le deuxième couloir chaud 152c.

Pour assurer la régulation en température, l'ensemble conteneur 100 comporte également au moins un condenseur 160, au moins un évaporateur 162 et un circuit frigorifique 164 qui assure la circulation d'un fluide caloporteur entre chaque évaporateur 162 et ledit au moins un condenseur 160. Ainsi, le fluide caloporteur se charge en calories de l'air du volume intérieur 150 au niveau de chaque évaporateur 162 puis le fluide circule jusqu'audit au moins un condenseur 160 où les calories sont transférées vers l'air extérieur qui est en contact avec ledit au moins un condenseur 160 et le fluide retourne à chaque évaporateur 162.

La circulation du fluide caloporteur est assurée par une pompe prévue à cet effet dans le circuit frigorifique 164.

Selon un mode de réalisation particulier non représenté, ledit au moins un condenseur 160 peut être à l'extérieur du conteneur 102 et l'air extérieur est alors directement en contact avec ledit au moins un condenseur 160.

Dans le mode de réalisation de l'invention représenté ici, ledit au moins un condenseur 160 est arrangé dans le conteneur 102 de manière à ce que l'ensemble conteneur 100 forme un bloc sans aspérités extérieures susceptibles d'être endommagées par exemple au cours d'un chargement/déchargement. Dans ce mode de réalisation, la paroi, ici la deuxième paroi latérale 102f, qui est au voisinage dudit au moins un condenseur 160, présente des trappes 168 qui sont ouvertes entre l'intérieur et l'extérieur du conteneur 102 pour assurer le passage de l'air extérieur.

Dans l'invention, pour chaque fenêtre de rejet 108b-c, l'ensemble conteneur 100 comporte au moins un évaporateur 162 qui est arrangé dans le volume de circulation 160 entre ladite fenêtre de rejet 108b-c et la fenêtre d'introduction 108a et chaque évaporateur 162 comporte un ventilateur 162a qui est arrangé pour générer un flux d'air de ladite fenêtre de rejet 108b-c vers la fenêtre d'introduction 108a. Dans la présente invention, on dit qu'un évaporateur 162 est entre une fenêtre de rejet 108b-c et la fenêtre d'introduction 108a lorsque le flux d'air allant de ladite fenêtre de rejet 108b-c à la fenêtre d'introduction 108a passe par ledit évaporateur 162.

Chaque ventilateur 162a génère ainsi un flux d'air à l'intérieur de l'évaporateur 162 qui pousse l'air vers la fenêtre d'introduction 108a. L'air ainsi poussé passe alors dans le couloir froid 152a puis traverse les racks 106, où il se charge en calories en contact avec les modules électriques et sort dans l'un ou l'autre des couloirs chauds 152b-c. L'air ainsi chauffé retraverse le faux plafond au niveau d'une fenêtre de rejet 108b-c pour entrer à nouveau dans un évaporateur 162 où il est déchargé de ses calories.

Les flèches 10 montrent le parcours de l'air.

Les modules électriques peuvent avoir des ventilateurs embarqués qui aident à créer le mouvement du flux d'air.

Un tel arrangement permet donc une régulation de la température dans le conteneur 102.

Ledit au moins condenseur 160 présente également préférentiellement un ventilateur pour aider au transfert des calories vers l'air extérieur.

Chaque évaporateur 162 comporte un tunnel 162b dans lequel est installé un échangeur thermique dans lequel le fluide caloporteur circule en étant entraîné par le ventilateur 162a correspondant et qui baigne dans l'air à refroidir.

De la même manière, ledit au moins un évaporateur 162 comporte un tunnel dans lequel est installé un échangeur thermique dans lequel le fluide caloporteur circule et qui baigne dans l'air à réchauffer.

Sur la Fig. 1, pour permettre une meilleure compréhension, les évaporateurs 162, les fenêtres 108a-c et le circuit frigorifique 164 sont représentés bien qu'ils soient en avant du plan de coupe. Les évaporateurs 162 sont représentés en trait mixte fin à deux tirets, les fenêtres 108a-c sont représentées en trait mixte fin à deux points et le circuit frigorifique 164 est représenté en trait mixte fin.

Dans le mode de réalisation de l'invention représenté à la Fig. 1, il y a plusieurs évaporateurs 162 (ici quatre) et ils délimitent ensemble un sous-volume 154 du volume de circulation 160. Ce sous-volume 154 est autour de la fenêtre d'introduction 108a et à l'intérieur par rapport aux fenêtres de rejet 108b-c, de manière à ce que l'air qui arrive à ladite fenêtre d'introduction 108a passe obligatoirement par l'un des évaporateurs 162 pour que seul l'air effectivement refroidi arrive à la fenêtre d'introduction 108a. Les évaporateurs 162 forment ainsi ensemble une barrière et pour que l'air provenant de l'une ou l'autre des fenêtres de rejet 108b-c arrive jusqu'à la fenêtre d'introduction 108a, il doit passer à travers l'un des évaporateurs 162.

À cette fin, le sous-volume 154 est étanche par rapport au reste du volume de circulation 160 dans le sens où seul l'air qui passe à travers les évaporateurs 162 et est donc refroidi, pénètre dans ledit sous-volume 154.

Dans le mode de réalisation de l'invention, la paroi frontale 102c ferme un des côtés du sous-volume 154, mais en positionnant la fenêtre d'introduction 108a de manière plus centrale, il est possible de mettre des évaporateurs 162 sur ce côté. La hauteur entre le plafond 102b et le faux plafond 108 est également dimensionnée pour que les évaporateurs 162 y soient placés en limitant les passages d'air entre les évaporateurs 162 et le plafond 102b, d'une part, et le faux plafond 108 d'autre part. Des joints peuvent éventuellement être ajoutés pour limiter le passage de l'air.

Le sous-volume 154 est donc limité par le plafond 102b, le faux plafond 108, les évaporateurs 162 et éventuellement d'autres parois (comme ici la paroi frontale 102c) assurant la séparation entre l'intérieur du sous-volume 154 où la fenêtre d'introduction 108a est arrangée et l'extérieur du sous-volume 154 où les fenêtres de rejet 108b-c sont arrangées.

Pour orienter le flux d'air froid pénétrant dans le couloir froid 152a par la fenêtre d'introduction 108a, des ailettes 166 qui sont orientables et arrangées dans ladite fenêtre d'introduction 108a. Ces ailettes permettent d'orienter le flux d'air froid vers les zones à refroidir en priorité.

Dans le mode de réalisation de l'invention représenté sur les Figs., le conteneur 102 comporte en outre une paroi de séparation 103 qui est disposée entre la deuxième rangée 104b et la deuxième paroi latérale 102f. Un volume technique 105 est ainsi délimité entre la paroi de séparation 103 et la deuxième paroi latérale 102f.

Ledit au moins un condenseur 160 est disposé dans le volume technique 105 de manière à ne pas générer de calories dans le deuxième couloir chaud 152c et à ne pas générer de perturbations électromagnétiques sur les modules électriques.

Pour alimenter les différents éléments de l'ensemble conteneur 100, il est possible de connecter ce dernier à un point de connexion électrique extérieur mais selon un mode de réalisation préféré de l'invention, un générateur électrique 161 embarqué dans ledit volume technique 105. Pour faciliter la maintenance des éléments contenus dans le volume technique 105, la deuxième paroi 102fprésente une porte extérieure 155 assurant l'accès audit volume technique 105 depuis l'extérieur du conteneur 102 et ici, les trappes 168 de la deuxième paroi latérale 102f sont réalisées dans la porte extérieure 155.

Pour pouvoir accéder à chaque couloir chaud 152b-c, l'une des parois délimitant ledit couloir chaud 152b-c présente une porte extérieure 153b-c assurant l'accès audit couloir chaud 152b-c depuis l'extérieur. Pour le premier couloir chaud 152b, la première paroi latérale 102e est équipée d'une telle porte extérieure 153b mais la première paroi latérale 102e pourrait être équipée de cette porte extérieure 153b. Pour le deuxième couloir chaud 152c, la paroi frontale 102c est équipée d'une telle porte extérieure 153c. La paroi frontale 102c est ainsi celle qui présente une porte extérieure 153c d'accès au deuxième couloir chaud 152c entre une rangée 104b et la paroi de séparation 103.

Pour accéder au couloir froid 152a, il est également possible de mettre une porte dans la paroi frontale 102c ou la paroi dorsale 102d, mais selon un mode de réalisation préféré et afin de limiter les ouvertures dans le conteneur 102, l'une des rangées 104a-b, ici la première rangée 104a, présente une porte intérieure 153a assurant l'accès au couloir froid 152a depuis le couloir chaud 152b-c associé à ladite rangée 104a-b.

## Revendications

1. Ensemble conteneur (100) comportant :
- un conteneur (102) comportant un plancher (102a), un plafond (102b), une paroi frontale (102c), une paroi dorsale (102d), une première paroi latérale (102e) et une deuxième paroi latérale (102f),
- une première rangée (104a) de racks (106) et une deuxième rangée (104b) de racks (106), où chaque rangée (104a-b) s'étend entre la paroi frontale (102c) et la paroi dorsale (102d) de manière à diviser un volume intérieur (150) du conteneur (102) en un couloir froid (152a) entre les deux rangées (104a-b), un premier couloir chaud (152b) entre la première paroi latérale (102e) et la première rangée (104a) et un deuxième couloir chaud (152c) entre la deuxième paroi latérale (102f) et la deuxième rangée (104b),
- un faux plafond (108) s'étendant entre les racks (106) et le plafond (102b) de manière à délimiter entre le plafond (102b) et le faux plafond (108), un volume de circulation (160), où le faux plafond (108) est traversé par une fenêtre d'introduction (108a) débouchant entre le volume de circulation (160) et le couloir froid (152a), une première fenêtre de rejet (108b) débouchant entre le volume de circulation (160) et le premier couloir chaud (152b) et une deuxième fenêtre de rejet (108c) débouchant entre le volume de circulation (160) et le deuxième couloir chaud (152c),
- au moins un condenseur (160) arrangé dans le conteneur (102),
- pour chaque fenêtre de rejet (108b-c), au moins un évaporateur (162) arrangé dans le volume de circulation (160) entre ladite fenêtre de rejet (108b-c) et la fenêtre d'introduction (108a), où chaque évaporateur (162) comporte un ventilateur (162a) arrangé pour générer un flux d'air de ladite fenêtre de rejet (108b-c) vers la fenêtre d'introduction (108a), et
- un circuit frigorifique (164) arrangé pour assurer la circulation d'un fluide caloporteur entre chaque évaporateur (162) et ledit au moins un condenseur (160).

2. Ensemble conteneur (100) selon la revendication 1, **caractérisé en ce que** les évaporateurs (162) délimitent ensemble un sous-volume (154) du volume de circulation (160) autour de la fenêtre d'introduction (108a), où le sous-volume (154) est étanche par rapport au reste du volume de circulation (160).

3. Ensemble conteneur (100) selon l'une des revendications 1 ou 2, **caractérisé en ce que** le conteneur (102) comporte une paroi de séparation (103) entre la deuxième rangée (104b) et la deuxième paroi latérale (102f) délimitant un volume technique (105) entre la paroi de séparation (103) et la deuxième paroi latérale (102f) et **en ce que** ledit au moins un condenseur (160) est disposé dans ledit volume technique (105).

4. Ensemble conteneur (100) selon la revendication 3, **caractérisé en ce qu'**il comporte un générateur électrique (161) embarqué dans ledit volume technique (105).

5. Ensemble conteneur (100) selon l'une des revendications 3 ou 4, **caractérisé en ce que** la deuxième paroi (102f) présente une porte extérieure (155) assurant l'accès audit volume technique (105).

6. Ensemble conteneur (100) selon l'une des revendications 1 à 5, **caractérisé en ce que** pour chaque couloir chaud (152b-c), la paroi frontale (102c) et/ou la première paroi latérale (102e) délimitant ledit couloir chaud (152b-c) présente une porte extérieure (153b-c) assurant l'accès audit couloir chaud (152b-c).

7. Ensemble conteneur (100) selon la revendication 6, **caractérisé en ce que** l'une des rangées (104a-b) présente une porte intérieure (153a) assurant l'accès audit couloir froid (152a) depuis le couloir chaud (152b-c) associé à ladite rangée (104a-b).
